# EUROPÄISCHE PATENTSCHRIFT

(11) **EP 3 387 165 B1**
(45) Veröffentlichungstag und Bekanntmachung des Hinweises auf die Patenterteilung: **02.08.2023**
(21) Anmeldenummer: 16819015.5
(22) Anmeldetag: 08.12.2016
(51) Int. Cl.: C25F 3/12, H01L 21/02, H01L 21/306, H01M 4/1395, C25F 7/00, H01L 21/677, H01L 21/67, H01M 4/134

(54) **VORRICHTUNG UND VERFAHREN ZUM EINSEITIGEN ÄTZEN EINES HALBLEITERSUBSTRATS**
APPARATUS AND METHOD FOR SINGLE-SIDED ETCH OF A SEMICONDUCTOR WAFER
APPAREIL ET MÉTHODE POUR GRAVURE D'UN COTÉ D'UNE PLAQUETTE SEMICONDUCTEUR

(30) Priorität: 11.12.2015 DE 102015121636
(43) Veröffentlichungstag der Anmeldung: 17.10.2018
(73) Patentinhaber: Nexwafe GmbH, 79108 Freiburg (DE)
(72) Erfinder: REBER, Stefan, 79194 Gundelfingen (DE); SCHILLINGER, Kai, 79106 Freiburg (DE)
(74) Vertreter: LBP Lemcke, Brommer & Partner Patentanwälte mbB
(86) Internationale Anmeldenummer: PCT/EP2016/080327
(87) Internationale Veröffentlichungsnummer: WO 2017/097933

(56) Entgegenhaltungen:
- DE-A1- 19 936 569
- DE-A1-102006 033 353
- DE-A1-102013 221 522
- US-A1- 2005 199 511
- US-A1- 2012 145 553
- US-A1- 2013 171 808
- Abel Santos ET AL: "Electrochemical Etching Methods for Producing Porous Silicon" In: "SPRINGER SERIES IN MATERIALS SCIENCE", 19. Juli 2015 (2015-07-19), SPRINGER, BERLIN, DE, XP055344340, ISSN: 0933-033X Bd. 220, Seiten 1-36, DOI: 10.1007/978-3-319-20346-1_1, Seite 16 - Seite 17; Abbildung 1.8

## Beschreibung

Die Erfindung betrifft eine Vorrichtung und ein Verfahren zum einseitigen Ätzen einer Halbleiterschicht gemäß dem Oberbegriff der Ansprüche 1 und 7.

Im Herstellungsverfahren von Halbleiterwafern oder Halbleiterbauelementen ist es häufig wünschenswert, einen Ätzvorgang an lediglich einer Seite einer Halbleiterschicht durchzuführen.

Hierzu kann die nicht zu ätzende Seite mit einer Ätz-Schutzschicht versehen werden, so dass in einem nachfolgenden, Ätzvorgang lediglich die nicht von der Schutzschicht bedeckte Seite bearbeitet wird. Ein derartiges Vorgehen ist jedoch verfahrensaufwändig, da die Schutzschicht aufgebracht und wieder abgenommen werden muss.

Es sind daher Verfahren bekannt, bei welchen lediglich die zu ätzende Seite der Halbleiterschicht mit einem Elektrolyten benetzt wird. Mittels einer Konstantstromquelle wird ein Ätzstrom zwischen dem Elektrolyten und der Halbleiterschicht erzeugt, so dass ein einseitiges Ätzen erfolgt.

Ein solches Verfahren und eine hierfür geeignete Vorrichtung ist aus DE 10 2013 219 886 A1 bekannt. Hierbei wird mittels einer Transportvorrichtung die Halbleiterschicht derart über einen Elektrolyten in einer Ätzkammer bewegt, dass im Wesentlichen nur die dem Elektrolyten zugewandte Seite der Halbleiterschicht mit dem Elektrolyten benetzt wird.

Aus der DE 10 2013 221 522 A1 ist eine Vorrichtung und ein Verfahren zur kontinuierlichen Herstellung poröser Siliziumschichten mittels einseitigem Ätzen bekannt, wobei ein elektrisch kontaktiertes Werkstück mittels einer Transportvorrichtung mit der zu ätzenden Oberfläche des Werkstücks an einer einen Elektrolyten und zwei Kathoden enthaltenen Ätzkammer vorbeigeführt wird, wobei zur Vermeidung einer Variation des Ätzergebnisses beim Ein- und Ausfahren des Werkstücks der Ätzstrom dynamisch so angepasst werden kann, dass die auf das Werkstück einwirkende Ätzstromdichte zu jeder Zeit konstant bleibt.

Aus der US 2005/0199511 A1 ist ein Verfahren zum elektrochemischen Ätzen im Rahmen der Herstellung einer porösen Halbleiterschicht bekannt, wobei ein Halbleitersubstrat in einer elektrochemischen Ätzvorrichtung eines Ätzsystems angeordnet wird, und wobei die Ätzparameter über einen Ätzzeitraum in Abhängigkeit des Widerstands des gesamten Ätzsystems angepasst werden.

Es besteht ein großer Bedarf, die Anwendungsbereiche des vorbeschriebenen Ätzverfahrens zu erweitern und die Fehleranfälligkeit zu verringern, um die Verwendung in industriellen Prozessen mit einem hohen Durchsatz zu ermöglichen.

Der vorliegenden Erfindung liegt daher die Aufgabe zugrunde, das vorbekannte Verfahren und die vorbekannte Vorrichtung zum einseitigen Ätzen einer Halbleiterschicht weiterzubilden, in dem die Fehleranfälligkeit verringert und/oder die Anwendungsbereiche vergrößert werden.

Gelöst ist diese Aufgabe durch eine Vorrichtung zum einseitigen Ätzen einer Halbleiterschicht gemäß Anspruch 1 sowie durch ein Verfahren zum einseitigen Ätzen einer Halbleiterschicht gemäß Anspruch 7 und die in Anspruch 15 aufgeführten Verwendungen.

Die Vorrichtung gemäß Anspruch 1 ist bevorzugt zur Durchführung des erfindungsgemäßen Verfahrens, insbesondere einer bevorzugten Ausführungsform hiervon, ausgebildet. Das erfindungsgemäße Verfahren ist bevorzugt zur Durchführung mittels der erfindungsgemäßen Vorrichtung, insbesondere einer bevorzugten Ausführungsform hiervon, ausgebildet.

Die erfindungsgemäße Vorrichtung zum einseitigen Ätzen einer Halbleiterschicht weist ein Ätzbecken zur Aufnahme eines Elektrolyten auf. Weiterhin weist die Vorrichtung eine erste Elektrode (zur Ausbildung einer Anode), welche zur elektrischen Kontaktierung des sich bei Benutzung in dem Ätzbecken befindenden Elektrolyten angeordnet ist sowie zumindest eine zweite Elektrode (zur Ausbildung einer Kathode), welche zur mittelbaren oder unmittelbaren elektrischen Kontaktierung der Halbleiterschicht angeordnet ist.

Die Vorrichtung weist weiterhin zumindest eine elektrische Stromquelle auf, welche mit der ersten und der zweiten Elektrode zum Erzeugen eines Ätzstroms elektrisch leitend verbunden ist. Weiterhin weist die Vorrichtung zumindest eine Transportvorrichtung zum Transport der Halbleiterschicht relativ zu dem Ätzbecken auf. Der Transport erfolgt derart, dass im Wesentlichen nur eine zu ätzende Ätzseite der Halbleiterschicht durch den sich bei Benutzung in dem Ätzbecken befindenden Elektrolyten benetzbar ist.

Die zu ätzende Halbleiterschicht kann hierbei eine Halbleiterscheibe, insbesondere ein Halbleiterwafer sein. Ebenso kann die Halbleiterschicht eine mittelbar oder unmittelbar auf ein Trägersubstrat aufgebrachte Halbleiterschicht sein.

Ebenso kann die Halbleiterschicht intrinsisch oder dotiert sein. Die erfindungsgemäße Vorrichtung und das erfindungsgemäße Verfahren eignen sich insbesondere zum einseitigen Ätzen einer Silizium-Halbleiterschicht und insbesondere eines Siliziumwafers.

Der Elektrolyt ist hierbei derart ausgebildet, dass in Zusammenwirkung mit dem Ätzstrom, welcher zwischen den beiden Elektroden und somit auch zwischen dem Elektrolyten und der Halbleiterschicht fließt, ein Ätzen der Halbleiterschicht an dem Bereich erfolgt, welche mit dem Elektrolyten benetzt sind und in welchem der Ätzstrom fließt.

Wesentlich ist, dass die Stromquelle als variable Stromquelle ausgebildet ist und das die Vorrichtung eine Steuereinheit zur Steuerung der variablen Stromquelle aufweist. Die Vorrichtung ist dabei derart ausgebildet, dass der Ätzstrom während des Ätzvorgangs mittels der Steuereinheit automatisch änderbar ist, wobei die Vorrichtung einen Sensor zur Detektion von Geometrie- oder Materialeigenschaften der Halbleiterschicht aufweist und der Sensor mit der Steuereinheit zusammenwirkend ausgebildet ist, um den Ätzstrom abhängig von den Sensordaten zu steuern.

Bei der erfindungsgemäßen Vorrichtung erfolgt somit während des Ätzvorgangs ein Ändern des Ätzstroms, ohne dass es hierfür einen manuellen Eingriff seitens eines Benutzers bedarf.

Hierdurch wird das Einsatzgebiet der Vorrichtung erweitert und/oder die Fehleranfälligkeit verringert:
Ätzvorgänge sind typischerweise zumindest hinsichtlich der Ätzgeschwindigkeit abhängig von dem Ätzstrom, so dass durch ein automatisches Variieren des Ätzstroms ein breiter Anwendungsbereich zum Erzeugen gezielt inhomogener Schichten, insbesondere in einer Richtung senkrecht zur Ätzseite der Halbleiterschicht inhomogene Schichten oder Schichtsysteme erschlossen wird:
So ist die erfindungsgemäße Vorrichtung insbesondere geeignet, die Halbleiterschicht an der Ätzseite zu porosifizieren. Hierbei wird der Umstand genutzt, dass unterschiedliche Ätzgeschwindigkeiten in Tiefenrichtung (senkrecht zur Ätzoberfläche) demgegenüber geringeren Ätzgeschwindigkeiten in einer Richtung parallel zur Ätzoberfläche vorliegen. Es ist an sich bekannt, mittels solcher Ätzverfahren poröse Oberflächenschichten an der Halbleiterschicht zu erzeugen, insbesondere poröse Oberflächenschichten bei Silizium-Halbleiterschichten.

Die erfindungsgemäße Vorrichtung erweitert nun die Anwendungsmöglichkeiten, in dem durch Vorgabe einer automatischen Ätzstromänderung während des Ätzvorgangs mittels der Steuereinheit in Tiefenrichtung unterschiedlich poröse Schichten ausgebildet werden können. Insbesondere wird bevorzugt ein Schichtsystem aus abwechselnd nieder- und hochporösen Teilschichten ausgebildet.

Solche Schichtsysteme werden bevorzugt durch zyklische Modulation des Ätzstroms mittels der Steuereinheit insbesondere durch Aufmodulation eines Sinus- oder Rechteckprofils erzeugt.

Die Messwerte des Sensors zur Detektion von Geometrie- oder Materialeigenschaften der Halbleiterschicht werden von der Steuereinheit dazu genutzt, das Profil des Ätzstroms, insbesondere dessen Maximalhöhe, an die Eigenschaften der Halbleiterschicht anzupassen.

Die Steuereinheit ist somit bevorzugt derart ausgebildet, dass der Ätzstrom durch Vorgabe eines zeitlichen Verlaufs steuerbar ist, insbesondere durch Vorgabe eines zeitlich modulierten, insbesondere sinus- oder rechteckartig modulierten Ätzstroms.

Eine weitere Vergrößerung des Anwendungsbereichs ergibt sich, indem während des Transports der Halbleiterschicht mittels der Transportvorrichtung relativ zu dem Ätzbecken eine Variation des Ätzstroms erfolgt. Hierdurch können unterschiedliche Schichteigenschaften in lateraler Richtung (d. h. in Transportrichtung) erzeugt werden. Ebenfalls kann die Ätzstromdichte (Strom pro stromdurchflossener Fläche) bei durch den Transport veränderlicher zu ätzender Fläche konstant gehalten werden, wie weiter unten detailliert beschrieben.

Das erfindungsgemäße Verfahren ist zum einseitigen Ätzen einer Halbleiterschicht mittels eines Ätzstroms zwischen einem Elektrolyten und der Halbleiterschicht ausgebildet, wobei die Halbleiterschicht mittels einer Transportvorrichtung relativ zu einem Ätzbecken derart transportiert wird, dass im Wesentlichen nur ei-ne zu ätzende Ätzseite der Halbleiterschicht durch einen sich bei Benutzung in dem Ätzbecken befindenden Elektrolyten benetzt wird, wobei der sich bei Benutzung in dem Ätzbecken befindende Elektrolyte mittels einer ersten Elektrode und die Halbleiterschicht mittels zumindest einer zweiten Elektrode kontaktiert wird, und wobei die erste und die zweite Elektrode zum Erzeugen eines Ätzstroms über zumindest eine elektrische Stromquelle, welche als variable Stromquelle ausgebildet ist, elektrisch leitend verbunden wird. Die Halbleiterschicht ist hierbei im Wesentlichen einseitig von dem Elektrolyten benetzt. Wesentlich ist, dass während des Ätzvorgangs der Ätzstrom mittels einer Steuereinheit zur Steuerung der variablen Stromquelle automatisch variiert wird, wobei mittels eines Sensors Geometrie- oder Materialeigenschaften der Halbleiterschicht detektiert werden und der Sensor mit der Steuereinheit zusammenwirkend ausgebildet ist, um den Ätzstrom abhängig von den Sensordaten zu steuern. Hierdurch ergeben sich die zuvor beschriebenen Vorteile.

Untersuchungen des Anmelders haben darüber hinaus ergeben, dass eine häufige Fehlerquelle bei der Weiterverwendung der einseitig geätzten Halbleiterschicht daher auftritt, dass an den Rändern der Halbleiterschicht in Transportrichtung Inhomogenitäten auftreten. Ausführliche Untersuchungen zeigten, dass bei Eintritt der Halbleiterschicht in das Ätzbecken, d. h. in einer Eingangsphase, in welcher die Halbleiterschicht mittels der Transportvorrichtung erstmals mit dem Elektrolyten in Kontakt kommt und somit ein erster, in Transportrichtung vorne liegender Randbereich der Halbleiterschicht geätzt wird, besonders hohe Ätzstromdichten bei bisher bekannten Vorrichtung und Verfahren auftreten. Dies wird verursacht durch den durch Konstantstromquellen aufgeprägten konstanten Stromfluss bei veränderlicher, zu ätzender Fläche.

Ein ähnlicher Effekt tritt bei Herausfahren der Halbleiterschicht auf. Sofern die Halbleiterschicht durch Ändern der Transportrichtung rückwärts wieder herausgefahren wird, tritt dieser Effekt nochmals an dem bereits zuvor beschriebenen Rand auf. Typischerweise wird die Halbleiterschicht jedoch über das Ätzbecken hinweggefahren, so dass der zuvor beschriebene, in Transportrichtung vorne liegende Rand zuerst aus dem Ätzbecken austritt und ein diesem Rand gegenüber liegender, in Transportrichtung hinten liegender Rand bei Abschluss des Bearbeitungsvorgangs das Ätzbecken verlässt und sich an diesem Rand die Verbindung zwischen dem Elektrolyten und der Halbleiterschicht löst. Auch an diesem hinteren Rand treten gemäß Untersuchungen des Anmelders Inhomogenitäten aufgrund sich stark erhöhender Ätzstromdichten auf.

In einer besonders vorteilhaften Ausführungsform ist die Steuereinheit somit derart ausgebildet, dass der Ätzstrom durch Vorgabe eines zu Beginn des Ätzvorgangs anschwellenden und/oder zum Ende des Ätzvorgangs abschwellenden Ätzstroms vorgebbar ist. Bevorzugt wird sowohl ein zu Beginn des Ätzvorgangs anschwellender, als auch ein zum Ende des Ätzvorgangs abschwellender Ätzstroms vorgegeben, bevorzugt wird der Stromfluss derart moduliert, dass eine gleichbleibende Ätzstromdichte erzielt wird.

Hierdurch kann der Ätzstrom bei Einfahren der Halbleiterschicht in das Ätzbecken und/oder bei Ausfahren aus dem Ätzbecken derart vorgegeben werden, dass ein homogener Ätzvorgang über die gesamte Fläche der Halbleiterschicht erfolgt und somit die in Transportrichtung vorne und hinten liegenden Randbereiche nicht mehr die bisher auftretenden Inhomogenitäten aufweisen.

Die Änderung des Ätzstroms erfolgt hierbei bevorzugt durch Vorgeben einer ansteigenden Rampe bei Einfahren in das Ätzbecken und entsprechend einer abnehmenden Rampe bei Herausfahren aus dem Ätzbecken. Insbesondere wird bei Einfahren in das Becken bevorzugt ein stetig ansteigender Ätzstrom vorgegeben und bei Herausfahren aus dem Becken bevorzugt ein stetig abnehmender Ätzstrom. Die zu ätzenden Halbleiterschichten weisen dabei eine bevorzugte Länge von 100 mm bis 1500 mm, insbesondere von 150 bis 250 mm auf. Die Höhe des Ätzstroms im Verlauf der Rampe ist dabei vorzugsweise verknüpft mit dem Flächenanteil der sich bereits bzw. noch in dem Ätzbecken befindlichen im Vergleich zum maximal im Ätzbecken ätzbaren Halbleiterschicht. Die eingesetzten Ätzströme variieren hierbei beispielsweise bei einer 156mm langen Halbleiterschicht von 0 bis 50 A, insbesondere von 0 bis 30 A.

Bevorzugt ist zwischen dem anschwellenden und dem abschwellendem Verlauf des Ätzstroms eine Plateauphase mit konstantem Ätzstrom vorgegeben. Typischerweise ergibt sich bei Bewegen der Halbleiterschicht relativ zu der Ätzkammer eine Zwischenphase, in welcher sich die Größe der durch den Elektrolyten benetzten Fläche der Halbleiterschicht nicht ändert. Dies kann darin begründet sein, dass die Länge der Halbleiterschicht in Transportrichtung größer als die entsprechende Länger der Ätzkammer ist und somit in der Zwischenphase die Halbleiterschicht die Ätzkammer zumindest in Transportrichtung vollständig überdeckt. Ebenso kann solch eine Zwischenphase auftreten, wenn die Länge der Ätzkammer in Transportrichtung größer als die entsprechende Länge der Halbleiterschicht ist und somit in der Zwischenphase die Halbleiterschicht zumindest in Transportrichtung vollständig mit dem Elektrolyten benetzt ist.

Vorteilhafterweise ist für die Zwischenphase ein konstanter Ätzstrom vorgegeben, da sich in der Zwischenphase die benetzte Fläche nicht ändert.

In einer vorteilhaften Ausgestaltung werden beim Einfahren und/oder beim Herausfahren Inhomogenitäten vermieden, in dem beim Einfahren der Ätzstrom ansteigt, insbesondere bevorzugt proportional zu der von dem Elektrolyten benetzten Fläche ansteigt. Alternativ oder insbesondere bevorzugt zusätzlich nimmt der Ätzstrom beim Herausfahren ab, insbesondere bevorzugt proportional zu der vom Elektrolyten bedeckten Fläche.

Bei gleichzeitigem Ein- und Ausfahren mehrerer Halbleiterschichten in/aus einem Ätzbecken wird in einer vorteilhaften Ausgestaltung der Ätzstrom so moduliert, dass durch Superposition der jeweiligen an- und abschwellenden Ätzströme eine zu jeder Zeit konstante Ätzstromdichte auf die Halbleiterschichten gewährleistet ist. Dies wird beispielsweise bei beabstandet voneinander in das Ätzbecken ein- und ausfahrende Halbleiterschichten, wenn der Abstand kleiner als die Länge des Ätzbeckens ist, in vorteilhafter Weise angewendet. Dabei wird beim Ausfahren der ersten Halbleiterschicht der Ätzstrom in bereits beschriebener Weise proportional zur abnehmenden Fläche reduziert, sobald eine zweite Halbleiterschicht in das Ätzbecken einfährt der Ätzstrom konstant gehalten, und, sobald die erste Halbleiterschicht das Ätzbecken vollständig verlassen hat der Ätzstrom flächenproportional erhöht bis die zweite Halbleiterschicht die gesamte Fläche des Ätzbeckens bedeckt und der Ätzstrom nunmehr konstant gehalten wird. Hierdurch kann der Ätzstrom zu jeder Zeit derart vorgegeben werden, dass ein homogener Ätzvorgang über die gesamte Fläche der Halbleiterschichten erfolgt und somit die in Transportrichtung vorne und hinten liegenden Randbereiche nicht mehr die bisher auftretenden Inhomogenitäten aufweisen.

Insbesondere ist es somit vorteilhaft, den Ätzstrom proportional zu der im Ätzbecken benetzten Halbleiterfläche zu variieren, wobei die benetzte Halbleiterfläche die Gesamte benetzte Halbleiterfläche ist, welche sich aus Teilflächen mehrerer Halbleiterschichten additiv zusammensetzen kann, sofern zumindest teilweise zwei oder mehrere Halbleiterschichten gleichzeitig im Ätzbecken von dem Elektrolyten benetzt sind.

Sofern der zeitliche Ablauf beim Transport der Halbleiterschicht mittels der Transportvorrichtung bekannt ist, kann durch Vorgabe eines zeitlichen Verlaufs des Ätzstroms die gewünschte Wirkung erzielt und/oder die gewünschte Homogenität sichergestellt werden.

In einer vorteilhaften Ausführungsform ist die Steuereinheit der Vorrichtung derart ausgebildet, dass der Ätzstrom abhängig von einem Steuersignal, insbesondere einem Detektorsignal steuerbar ist. Hierdurch kann der vorgegebene zeitliche Verlauf durch das Steuersignal getriggert werden. Insbesondere ist es vorteilhaft, dass ein Positionsdetektor zur Detektion zumindest einer Positionierung der Halbleiterschicht relativ zu dem Ätzbecken vorgesehen ist und das der Positionssensor mit der Steuereinheit zusammenwirkend ausgebildet ist, um ein Triggersignal zum Starten des vorgegebenen zeitlichen Verlaufs des Ätzstroms an die Steuereinheit zu senden.

Ein solcher Positionssensor kann in an sich bekannter Weise als mechanischer Schalter ausgebildet sein. Bevorzugt ist der Positionssensor als berührungsloser Positionssensor, insbesondere bevorzugt als Lichtschranke ausgebildet.

Der Positionssensor ist bevorzugt in Transportrichtung vor dem Ätzbecken angeordnet, so dass der in Transportrichtung vordere Rand bevorzugt unmittelbar oder kurz vor Eintreten in das Ätzbecken und somit kurz vor dem Benetzen des vorderen Randes mit dem Elektrolyten detektiert wird. Ebenso liegt es im Rahmen der Erfindung, den Positionssensor im größeren Abstand zu dem Rand des Ätzbeckens anzuordnen. Insbesondere bei Kenntnis der Transportgeschwindigkeit und insbesondere bevorzugt bei einer konstanten Transportgeschwindigkeit kann durch den entsprechenden Zeitversatz zwischen Detektion des vorderen Randes der Halbleiterschicht und Eintritt dieses Randes in das Ätzbecken berechnet werden. Weiterhin wird bevorzugt durch Detektion der Vorderkante (ein in Transportrichtung vorderer Rand) und der Endkante (ein in Transportrichtung hinterer Rand) der Halbleiterschicht die Transportgeschwindigkeit, sowie die Länge der Halbleiterschicht ermittelt werden, insbesondere wird bevorzugt somit die Stromrampe an jede Halbleiterschicht explizit angepasst werden.

In einer vorteilhaften Ausgestaltung weist die Vorrichtung mindestens einen weiteren Sensor zur Bestimmung der Identität der Halbleiterschicht. Die Messwerte dieses mindestens einen weiteren Sensors werden von einer geeigneten Verarbeitungseinheit, insbesondere der Steuereinheit, dazu genutzt, das Profil des Ätzstroms, insbesondere dessen Maximalhöhe an die Eigenschaften der Halbleiterschicht anzupassen.

Beispielsweise wird in einer vorteilhaften Ausführung ein Sensor zur Bestimmung der Leitfähigkeit der Halbleiterschicht verwendet, um anhand des Messwerts den Ätzstrom so anzupassen, dass die Ätzrate, die Abhängig von der Leitfähigkeit ist, konstant zu halten. In gleicher Weise wird ein Sensor zur Bestimmung der Fläche der Halbleiterschicht dazu genutzt, den Ätzstrom flächenproportional einzustellen um eine konstante Ätzstromdichte zu erzielen. Die Abhängigkeit der Ätzrate von der Leitfähigkeit ist beispielsweise aus E. V. Astrova, Y. A. Zharova, "Anisotropy of the Porous Layer Formation Rate in Silicon with

Various Acceptor Concentrations", Solid State Phenomena, Vols. 205-206, pp. 370-375, Oct. 2013 bekannt.

Zur Erzielung einer optimalen Homogenität ist die Vorrichtung bevorzugt derart ausgebildet, dass die Ätzstromdichte an der Halbleiterschicht während des Ätzvorgangs konstant ist, so dass pro Flächeneinheit und unabhängig von der Position der Halbleiterschicht stets in etwa der gleiche Ätzstrom einwirkt, was bei gleichbleibender Geschwindigkeit und damit gleicher Ätzzeit die gewünschte optimale Homogenität gewährleistet.

In einer weiter bevorzugten Ausführungsform erfolgt eine Kombination des zeitlich modulierten Ätzstroms mit einem Anstieg des Ätzstromes bei Einfahren der Halbleiterschicht in die Ätzkammer und/oder einem Abnehmen des Ätzstroms bei Herausfahren der Halbleiterschicht aus der Ätzkammer. In dieser bevorzugten Ausführungsform wird somit die zeitliche Modulierung, insbesondere bevorzugt eine sinusartige, rechteckartige, dreieckartige oder sägezahnartige Modulation einer ansteigenden Rampe beim Einfahren, einem mittleren Plateau und einer abnehmenden Rampe beim Herausfahren des Wafers überlagert.

In dieser bevorzugten Ausführungsform nimmt der Ätzstrom somit im zeitlichen Mittel beim Einfahren der Halbleiterschicht zu und/oder der Ätzstrom nimmt im zeitlichen Mittel bei Herausfahren der Halbleiterschicht ab.

Die erfindungsgemäße Vorrichtung und das erfindungsgemäße Verfahren sind insbesondere bevorzugt zum Herstellen einer porösen Halbleiterschicht oder zumindest einer porösen Oberfläche an der Halbleiterschicht wie zuvor beschrieben geeignet.

Insbesondere ist es vorteilhaft, mit der erfindungsgemäßen Vorrichtung und/oder mit dem erfindungsgemäßen Verfahren ein Trägersubstrat für eine epitaktische Abscheidung einer Halbleiterschicht, insbesondere für eine epitaktische Abscheidung einer Siliziumschicht auszubilden.

Ein solches Verfahren, bei welchem zunächst ein Trägersubstrat durch einseitiges Ausbilden einer porösen Oberfläche mittels Ätzen vorbereitet wird, anschließend auf der porösen Oberfläche eine Siliziumschicht epitaktisch ausgebildet wird, welche abschließend von dem Trägersubstrat abgelöst wird zur Herstellung eines Halbleiterbauelementes, insbesondere einer photovoltaischen Solarzelle, ist in WO 2013/004851 A1 beschrieben.

Das erfindungsgemäße Verfahren und die erfindungsgemäße Vorrichtung sind insbesondere zum Ausbilden einer porösen Oberfläche an einem Trägersubstrat zum epitaktischen Aufwachsen einer Siliziumschicht wie zuvor beschrieben geeignet.

Der Ätzstrom ist bevorzugt derart gewählt, dass sich eine Ätzstromdichte im Bereich von 0,1 mA/cm² bis 1000 mA/cm², insbesondere bevorzugt im Bereich 5 mA/cm² bis 500 mA/cm² ergibt.

Zum Erzielen einer vorteilhaften Ätzwirkung sind folgende Ausgestaltungen des Elektrolyten vorteilhaft:
Zum Erzeugen von porösem Silicium: 30% bis 80% deionisiertes Wasser, 19% bis 49% Flußsäure, Rest Tensid (z.B. Ethanol), z.B. 36% deionisiertes Wasser, 49% Flußsäure, 15% Ethanol. Anstatt Flußsäure können alternative dissoziierbare Fluor, Chlor oder andere Halogene enthaltende Verbindungen verwendet werden.

Zum Erzeugen von porösem Galliumarsenid sind Chlor enthaltende Elektrolyten, z.B. Salzsäure bevorzugt, zum Erzeugen von porösem Indiumphosphid sind Hydroxyl enthaltende Elektrolyten, z.B. Kalilauge bevorzugt, zum Erzeugen von porösem Siliciumcarbid sind Flußsäure enthaltende Elektrolyten bevorzugt.

Bei der erfindungsgemäßen Vorrichtung und dem erfindungsgemäßen Verfahren erfolgt der Stromfluss des Ätzstroms von der ersten Elektrode über den Elektrolyten zu der Halbleiterschicht. Es liegt im Rahmen der Erfindung, dass die zweite Elektrode die Halbleiterschicht mittelbar oder unmittelbar mechanisch kontaktiert. Eine vorteilhafte Ausführung eines solchen Kontakts ist beispielsweise ein federnd gelagerter Schleifkontakt aus Graphit- oder Metallbürsten.

Ebenso liegt es im Rahmen der Erfindung, andere Kontaktierungsarten zum elektrischen Kontaktieren der Halbleiterschicht mit der zweiten Elektrode vorzusehen, insbesondere eine der in DE 10 2013 219 839 A1 beschriebenen Ausführungsformen zu wählen.

Vorteilhafterweise ist in Transportrichtung zumindest vor dem Ätzbecken ein erstes Kontaktierungsbecken (zur Ausbildung einer Kathode) vorgesehen, welches bei Benutzung mit einem kontaktierenden Elektrolyten, bevorzugt dem identischen Elektrolyten wie im Ätzbecken verwendet, gefüllt ist. Die zweite Elektrode (zur Ausbildung einer Anode) ist bei dieser vorteilhaften Ausführungsform zur elektrischen Kontaktierung der sich bei Benutzung in dem Kontaktierungsbecken befindenden Kontaktflüssigkeit angeordnet.

Die Transportvorrichtung ist hierbei bevorzugt derart angeordnet und ausgebildet, dass die Halbleiterschicht zunächst mit der Kontaktflüssigkeit des Kathodenbeckens zumindest benetzt wird. Insbesondere ist es vorteilhaft, in gleicher Weise wie auch bei dem Ätzbecken die Halbleiterschicht mittels der Transportvorrichtung derart zu transportieren, dass im Wesentlichen nur die zu ätzende Seite der Halbleiterschicht mittels der sich bei Benutzung im Kontaktbecken befindenden Kontaktflüssigkeit benetzt wird. Bei Einfahren der Halbleiterschicht in das Ätzbecken wird somit die Halbleiterschicht beginnend am vorderen Rand von dem sich in dem Ätzbecken befindenden Elektrolyten benetzt (Anode), wohingegen der verbleibende Bereich der Halbleiterschicht noch von der Kontaktflüssigkeit des Kontaktbeckens (Kathode) benetzt ist. Hierdurch ist somit eine elektrische Kontaktierung der Halbleiterschicht einerseits durch die erste Elektrode mittels des Elektrolyten und andererseits durch die zweite Elektrode mittels der Kontaktflüssigkeit erfolgt, so dass der Ätzvorgang durch Ausbilden eines Ätzstroms gestartet werden kann.

Besonders vorteilhaft ist es, in Transportrichtung nach dem Ätzbecken ein zweites Kontaktierungsbecken (zur Ausbildung einer Kathode) vorzusehen, welches ebenfalls bei Benutzung mit Kontaktflüssigkeit gefüllt ist. In dem zweiten Kontaktierungsbecken ist eine dritte Elektrode (zur Ausbildung einer zweiten Kathode) zur Kontaktierung der sich bei Benutzung im zweiten Kontaktierungsbecken befindenden Kontaktflüssigkeit angeordnet. Die zweite Kathode ist ebenfalls elektrisch leitend mit der Stromquelle verbunden mit gleicher Polarität wie die erste Kathode. Insbesondere ist es vorteilhaft, dass beide Kathoden elektrisch leitend verbunden sind.

Hierdurch ergibt sich der Vorteil, dass bei Ausfahren der Halbleiterschicht aus dem Ätzbecken ein Einfahren der Halbleiterschicht in das zweite Kathodenbecken erfolgt, so dass nun das Fließen des Ätzstroms über die Anode und die zweite Kathode sichergestellt ist.

Vorteilhafterweise weist das Ätzbecken in Transportrichtung eine Länge auf, welche kleiner als die Länge der Halbleiterschicht in Transportrichtung ist, so dass stets ein Bereich der Halbleiterschicht über einen hinteren und/oder vorderen Rand des Ätzbeckens übersteht und in diesen überstehenden Bereichen stets eine Kontaktierung wie zuvor beschrieben zur Ausbildung des Ätzstroms gewährleistet werden kann.

Insbesondere ist es vorteilhaft, dass der zu dem Ätzbecken weisende Rand des ersten Kathodenbeckens und der zu dem Ätzbecken weisende Rand des zweiten Kathodenbeckens parallel zur Transportrichtung einen Abstand aufweisen, welcher kleiner als die Länge der Halbleiterschicht in Transportrichtung ist.

Das erfindungsgemäße Verfahren und die erfindungsgemäße Vorrichtung ist insbesondere für eine Ätztiefe im Bereich 0,01 µm bis 2000 µm geeignet, bevorzugt von 0,1 µm bis 50 µm.Insbesondere bei Verwendung der erfindungsgemäßen Vorrichtung und des erfindungsgemäßen Verfahrens zum Erzeugen einer porösen Oberfläche der Halbleiterschicht wird bevorzugt ein poröser Bereich mit einer Tiefe im Bereich 0,5 µm bis 5 µm erzeugt. Die Parameterbereiche für Ätzstrom, die Ausgestaltung der Elektroden, Ätzkammern, Transportvorrichtung und des Elektrolyten können in an sich bekannter Weise erfolgen, insbesondere wie in DE 10 2013 219 886 A1 beschrieben.

Weitere bevorzugte Merkmale und Ausführungsformen werden im Folgenden anhand von Ausführungsbeispielen und den Figuren beschrieben. Dabei zeigt:
- Figur 1: ein erstes Ausführungsbeispiel einer erfindungsgemäßen Vorrichtung mit zwei Kontaktierungskammern;
- Figur 2: ein zweites Ausführungsbeispiel einer erfindungsgemäßen Vorrichtung mit drei Ätzkammern;
- Figur 3: ein schematisch dargestellter zeitlicher Verlauf des Ätzstroms zum Erzielen einer homogenen Ätzwirkung;
- Figur 4: ein schematisch dargestellter zeitlicher Verlauf des Ätzstroms zum Erzielen einer lateral unterschiedlichen Ätzwirkung;
- Figur 5: ein schematisch dargestellter zeitlicher Verlauf eines sinusartig modulierten Ätzstroms;
- Figur 6: das Ergebnis einer Oberflächenbearbeitung mit dem in Figur 5 dargestellten Stromverlauf und
- Figur 7: ein schematisch dargestellter zeitlicher Verlauf eines sinusartig modulierten Ätzstroms mit einem dazwischen liegenden StromPeak.

Sämtliche Figuren zeigen schematische, nicht maßstabsgetreue Darstellungen. Gleiche Bezugszeichen in den Figuren bezeichnen gleiche oder gleichwirkende Elemente.

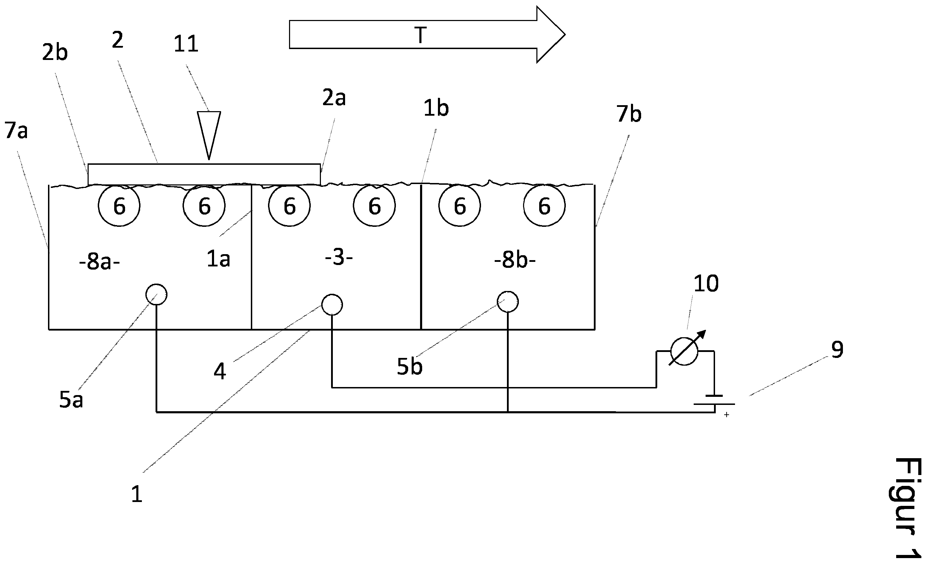

In Figur 1 ist ein erstes Ausführungsbeispiel einer erfindungsgemäßen Vorrichtung zum einseitigen Ätzen einer Halbleiterschicht 2 dargestellt. Die Halbleiterschicht 2 ist als Siliziumwafer mit einer Dicke von 100 µm bis 1500 µm, vorliegend 750 µm und einer Dotierung von 1×10¹⁵ Atome/cm³ bis 1×10²⁰ Atome/cm³, vorliegend 5×10¹⁸ Atome/cm³, dotiert mit entweder Bor oder Phosphor, vorliegend Bor, ausgebildet. Auf der unten liegenden Oberfläche der Halbleiterschicht 2 soll eine poröse Oberfläche erzeugt werden, so dass die Halbleiterschicht 2 als Trägersubstrat zum epitaktischen Aufwachsen einer Siliziumschicht verwendet werden kann.

Die derart hergestellte und anschließend von der Halbleiterschicht 2 abgelöste Siliziumschicht dient zum Herstellen eines Halbleiterbauelementes, insbesondere zum Herstellen einer photovoltaischen Solarzelle.

Die Vorrichtung weist ein Ätzbecken 1 (Anode) auf, welches mit einem Elektrolyten 3 gefüllt ist, mit folgender Zusammensetzung: 30% bis 80%, vorliegend 40%, H₂O; 19% bis 49%, vorliegend 40%, HF; Rest, vorliegend 20%, Tensid (z.B. Ethanol).

Eine erste Elektrode 4 ist in dem Ätzbecken 1 angeordnet, um den Elektrolyten 3 elektrisch zu kontaktieren.

Die Vorrichtung weist weiterhin eine Transportvorrichtung auf, von welcher zur besseren Übersichtlichkeit lediglich schematisch Transportrollen 6 dargestellt sind. Mittels der Transportrollen 6, welche durch einen nicht dargestellten motorischen Antrieb gleichsinnig und in gleicher Geschwindigkeit gedreht werden, wird die Halbleiterschicht 2 in eine Transportrichtung T bewegt, d. h. in der Darstellung gemäß Figur 1 von links nach rechts.

In Transportrichtung unmittelbar angrenzend an das Ätzbecken 1 ist jeweils ein Kontaktierungsbecken (Kathode) 7a (in Transportrichtung vor dem Ätzbecken) und 7b (in Transportrichtung nach dem Ätzbecken) angeordnet. Die Kontaktierungsbecken sind jeweils mit Kontaktierungsflüssigkeit 8a, 8b gefüllt, welche im Anwendungsbeispiel identisch ist zur Kontaktierungsflüssigkeit im Ätzbecken 1 (Anode)

In dem Kontaktierungsbecken 7a ist eine zweite Elektrode 5a (Kathode 1) und in dem Kontaktierungsbecken 7b eine dritte Elektrode 5b (Kathode 2) angeordnet, jeweils zum elektrischen Kontaktieren der Kontaktierungsflüssigkeit (8a, 8b).

Die Vorrichtung weist weiterhin eine Stromquelle 9 auf, welche einerseits mit der ersten Elektrode 4 (Anode) und andererseits mit der zweiten Elektrode 5a (Kathode 1) und der dritten Elektrode 5b (Kathode 2) elektrisch leitend verbunden ist. Dementsprechend sind beide Kathoden elektrisch leitend miteinander verbunden.

Wird nun die Halbleiterschicht 2 mittels der Transportvorrichtung in Transportrichtung T bewegt, so wird im Wesentlichen lediglich die unten liegende Seite der Halbleiterschicht 2 durch die Kontaktierungsflüssigkeit 8a, 8b bzw. den Elektrolyten 3 benetzt. Durch ein Spannungspotential zwischen der Anode (Elektrode 4) und einer der Kathoden (Elektrode 5a sowie Elektrode 5b) wird somit über den Elektrolyten 3 und die Kontaktierungsflüssigkeiten ein Ätzstrom erzeugt.

Wesentlich ist nun, dass die Stromversorgung als variable Stromquelle ausgebildet ist und eine Steuereinheit 10 vorgesehen ist. Die Steuereinheit ist mit der variablen Stromquelle zusammenwirkend ausgebildet, um den Ätzstrom während des Ätzvorgangs automatisch zu ändern.

Mittels der Steuereinheit 10 ist somit eine Änderung des Ätzstroms vorgebbar, insbesondere durch Vorgabe eines zeitlichen Verlaufs und/oder durch Vorgabe einer Änderung des Ätzstroms abhängig von Triggersignalen wie beispielsweise Sensordaten.

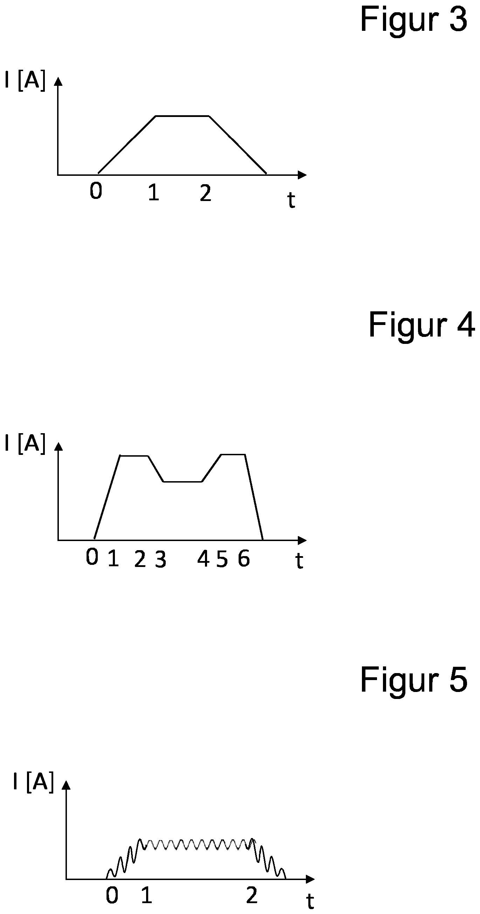

Hierdurch können Fehleranfälligkeiten verringert werden, insbesondere durch Erhöhung der Homogenität des Ätzvorgangs und/oder ein breiterer Anwendungsbereich verglichen mit vorbekannten Vorrichtungen erschlossen werden. Dies wird nachfolgend anhand von den Figuren 3 bis 6 erläutert werden.

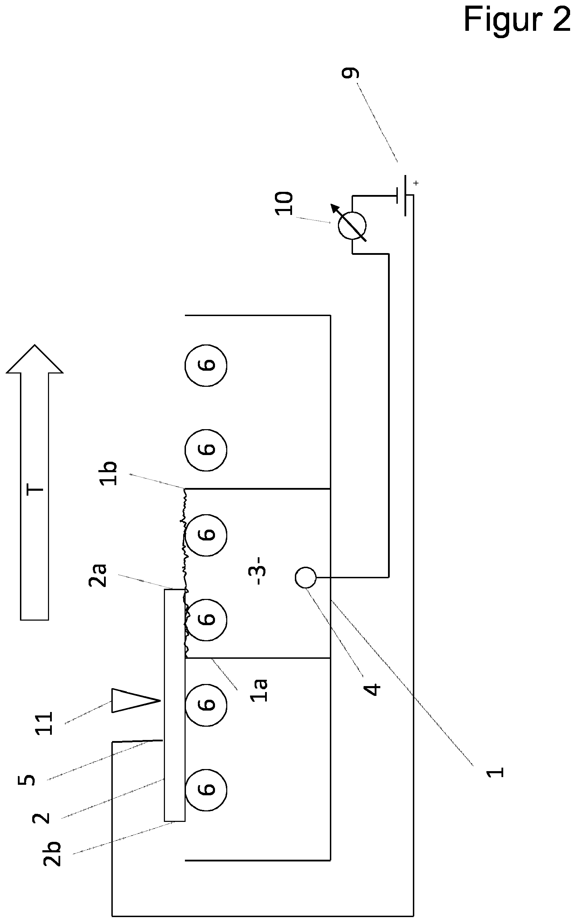

Figur 2 zeigt ein zweites Ausführungsbeispiel einer erfindungsgemäßen Vorrichtung. Zum Vermeiden von Wiederholungen wird nachfolgend lediglich auf die wesentlichen Unterschiede gegenüber der in Figur 1 dargestellten Vorrichtung eingegangen:
Bei der Vorrichtung gemäß Figur 2 wird die Halbleiterschicht 2 unmittelbar durch eine zweite Elektrode 5 (Kathode) kontaktiert. Diese Kathode (Elektrode 5) ist somit ortsfest an der Halbleiterschicht und läuft während des Transportvorgangs in Transportrichtung T mit.

Die Vorrichtung gemäß Figur 2 weist ein Ätzbecken 1 auf, welches mit einem Elektrolyten 3 gefüllt ist. Der Elektrolyt 3 im Ätzbecken 1 ist über die Elektrode (Anode) 4 kontaktiert. Die Zusammensetzung dieses Elektrolyten ist wie folgt: 30% bis 80% H₂O; 19% bis 49% HF; Rest Tensid (z.B. Ethanol).

Die variable Stromquelle 9 ist somit einerseits mit der Elektrode (Anoden) 4 elektrisch leitend verbunden. Andererseits ist die Stromquelle 9 mit der zweiten Elektrode 5 (Kathode) elektrisch leitend verbunden.

Die Vorrichtung gemäß Figur 1 und Figur 2 weisen zusätzlich einen Positionssensor 11 auf, welcher als Lichtschranke ausgebildet ist. Mittels des Positionssensors 11 lässt sich somit detektieren, wann ein in Transportrichtung vorderer Rand 2a der Halbleiterschicht den Ort des Positionssensors 11 erreicht. Der Positionssensor 11 ist mit der Steuereinheit 10 verbunden, um ein Triggersignal zu der Steuereinheit 10 zu senden.

In einem ersten Ausführungsbeispiel eines erfindungsgemäßen Verfahrens erfolgt mittels der Vorrichtung gemäß Figur 1 das Ausbilden eines Ätzstroms zwischen dem Elektrolyten 3 und der Halbleiterschicht 2, um die Halbleiterschicht 2 an der dem Elektrolyten zugewandten Seite einseitig zu ätzen. Hierbei ist - wie zuvor beschrieben - die Halbleiterschicht im Wesentlichen einseitig von dem Elektrolyten benetzt. Wesentlich ist, dass während des Ätzvorgangs der Ätzstrom automatisch mittels der Steuereinheit 10 variiert wird.

Weitere Ausführungsbeispiele eines erfindungsgemäßen Verfahrens werden nachfolgend anhand der Figuren 3 bis 6 erläutert:
Untersuchungen des Anmelders haben gezeigt, dass insbesondere beim Einfahren der Halbleiterschicht 2 in das Ätzbecken 1 und bei Ausfahren aus dem Ätzbecken 1 starke Inhomogenitäten im Ätzvorgang auftreten, insbesondere konnte in diesen Bereichen ein starker Anstieg der Ätzstromdichte ermittelt werden.

Die Figuren 3 bis 5 und 7 zeigen jeweils schematisch dargestellte, zeitliche Verläufe des Ätzstroms. Auf der X-Achse ist stets die Zeit t aufgetragen und auf der Y-Achse der Ätzstrom I.

In einem ersten Ausführungsbeispiel eines erfindungsgemäßen Verfahrens wird daher ein zeitlicher Verlauf des Ätzstroms I gemäß Figur 3 vorgegeben.

In diesem Ausführungsbeispiel des erfindungsgemäßen Verfahrens erfolgt zu einem Zeitpunkt t=0, wenn der vordere Rand 2a der Halbleiterschicht 2 in das Ätzbecken 1 einfährt, d. h. den Rand des Ätzbeckens 1 überschreitet und somit erstmals von dem Elektrolyten 3 benetzt wird ein rampenartiges, kontinuierliches Ansteigen des Ätzstroms bis zu einem Zeitpunkt t=1. Dieser Zeitpunkt t=1 stellt die Situation dar, bei welcher der vordere Rand 2a der Halbleiterschicht 2 dem hinteren Rand 1b des Ätzbeckens 1 erreicht. Zu diesem Zeitpunkt t=1 überdeckt die Halbleiterschicht 2 das Ätzbecken 1 somit zumindest in Transportrichtung T vollständig.

Wie in Figur 3 ersichtlich, erfolgt nun ein Plateauverlauf des Ätzstroms, d. h. der Ätzstrom wird bis zu einem Zeitpunkt t=2 konstant gehalten. Der Zeitpunkt t=2 ist derjenige Zeitpunkt, an dem der hintere Rand 2b der Halbleiterschicht 2 den vorderen Rand 1a des Ätzbeckens 1 erreicht. Ab dem Zeitpunkt t=2 ist somit das Ätzbecken (zumindest in Transportrichtung T) nicht mehr vollständig von der Halbleiterschicht 2 bedeckt. Wie in Figur 3 ersichtlich, erfolgt ab diesem Zeitpunkt t=2 ein rampenartiges, stetiges Abnehmen des Ätzstroms I.

Auf diese Weise kann eine erhebliche Verbesserung der Homogenität der Ätzwirkung insbesondere lateral in Transportrichtung erzielt werden, so dass bei der weiteren Verwendung der Halbleiterschicht 2 bisher auftretende Fehler vermieden oder zumindest erheblich verringert werden können.

Beispielsweise wird bei einer Vorschubgeschwindigkeit von 100 cm/min, einer Ätzbeckenlänge von 5 cm und einer Länge der Halbleiterschicht aus Silicium von 15 cm beim Einfahren in das Ätzbecken der Strom über 3s von 0 A auf 10A linear erhöht, dann für 3s konstant gehalten, und darauf folgend für 3s von 10A auf 0A abgesenkt. Dieses Verfahren erzeugt eine etwa 0,5 µm dicke poröse Siliciumschicht homogener Dicke.

In Figur 4 ist ein zweites Ausführungsbeispiel eines erfindungsgemäßen Verfahrens zum gezielten Erzeugen lateral unterschiedlicher Ätzwirkungen dargestellt:
In diesem Ausführungsbeispiel des erfindungsgemäßen Verfahrens erfolgt zu einem Zeitpunkt t=0, wenn der vordere Rand 2a der Halbleiterschicht 2 in das Ätzbecken 1 einfährt, d. h. den Rand des Ätzbeckens 1 überschreitet und somit erstmals von dem Elektrolyten 3 benetzt wird ein rampenartiges, kontinuierliches Ansteigen des Ätzstroms bis zu einem Zeitpunkt t=1. Dieser Zeitpunkt t=1 stellt die Situation dar, bei welcher der vordere Rand 2a der Halbleiterschicht 2 dem hinteren Rand 1b des Ätzbeckens 1 erreicht. Zu diesem Zeitpunkt t=1 überdeckt die Halbleiterschicht 2 das Ätzbecken 1 somit zumindest in Transportrichtung T vollständig.

Wie in Figur 4 ersichtlich, erfolgt nun ein Plateauverlauf des Ätzstroms, d. h. der Ätzstrom wird bis zu einem Zeitpunkt t=2 konstant gehalten. Ab Zeitpunkt t=2 wird der Ätzstrom variiert, in diesem Anwendungsbeispiel reduziert, bis zum Zeitpunkt t=3. Der reduzierte Ätzstrom wird bis zum Zeitpunkt t=4 konstant gehalten und anschließend rampenartig erhöht bis er zum Zeitpunkt t=5 das ursprüngliche Niveau erreicht hat. Dieses Niveau wird bis zum Zeitpunkt t=6 konstant gehalten. Der Zeitpunkt t=6 ist derjenige Zeitpunkt, an dem der hintere Rand 2b der Halbleiterschicht 2 den vorderen Rand 1a des Ätzbeckens 1 erreicht. Ab dem Zeitpunkt t=6 ist somit das Ätzbecken (zumindest in Transportrichtung T) nicht mehr vollständig von der Halbleiterschicht 2 bedeckt. Wie in Figur 4 ersichtlich, erfolgt ab diesem Zeitpunkt t=6 ein rampenartiges, stetiges Abnehmen des Ätzstroms I.

Auf diese Weise kann ein an den Randbereichen der Halbleiterschicht stärker ausgeprägter poröser Bereich erzeugt werden. Dies ist insbesondere vorteilhaft für die Wirkung der porösen Schicht als Trennschicht um eine epitaktisch auf die geätzte Schicht aufgebrachte Halbleiterschicht von der Halbleiterschicht 2 zu trennen, wie beschrieben in WO 2013/004851 A1. Alternativ kann auch in den Randbereichen durch ein Reduzieren des Stromniveaus zwischen t=1 und t=2, sowie zwischen t=5 und t=6 unter das Niveau welches zwischen t=3 und t=4 anliegt, ein bewusstes Anhaften der epitaktisch hergestellten Halbleiterschicht erreicht werden.

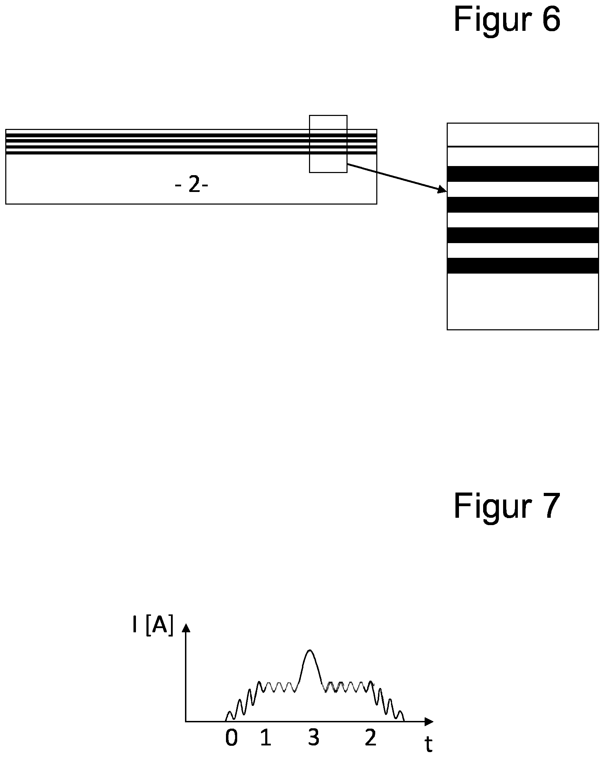

In Figur 5 ist die Variation des Ätzstroms bei einem weiteren Ausführungsbeispiel eines erfindungsgemäßen Verfahrens dargestellt:
In diesem Ausführungsbeispiel verläuft der Ätzstrom im Mittel wie in Figur 3 dargestellt. Zusätzlich wird der Ätzstrom jedoch sinusartig moduliert, wobei die Amplitude der sinusartigen Modulation kleiner ist als die Plateauhöhe zwischen den Zeitpunkten t=1 und t=2.Auch bei diesem Verfahren wird ein poröser Bereich an der Oberfläche der Halbleiterschicht hergestellt. Aufgrund der sinusartigen Modulation wird hierbei jedoch ein Schichtsystem aus übereinanderliegenden Schichten mit abwechselnd größerer und kleinerer Dichte erzeugt, wie in Figur 6 gezeigt:

Figur 6 zeigt eine Halbleiterschicht 2, welche mit dem zuvor beschriebenen Verfahren behandelt wurde, beispielsweise in einer Vorrichtung gemäß Figur 1. Die bei Durchführen des Verfahrens unten liegende Ätzseite, an welcher die porösen Schichten erzeugt werden, ist in Figur 6 oben liegend dargestellt. Im rechten Teilbild ist eine Ausschnittsvergrößerung gezeigt. Die weißen Schichten stellen hierbei Schichten mit geringer Dichte dar, bei denen somit durch einen höheren Ätzstrom mehr Material abgeätzt wurde. Die schwarz dargestellten Schichten weisen eine demgegenüber höhere Dichte auf, da aufgrund eines geringeren Ätzstroms weniger Material abgeätzt wurde.

Hierdurch können deutlich dünnere Lagen mit unterschiedlicher Dichte erzielt werden, da deutlich kürzere Ätzzeiten z.B. im Bereich <0,1s erzeugt werden. Bei ungeregeltem Ätzstrom sind diese Zeiten nur durch sehr hohe Überfahrtgeschwindigkeiten zu realisieren. Diese Geschwindigkeiten können in der Praxis nicht realisiert werden.

Eine solche, beispielsweise als optischer Reflektor verwendbare Schicht wird z.B. durch eine sinusförmige Modulation des Ätzsstroms mit einer Frequenz bevorzugt im Bereich 0,01 Hz bis 500 Hz, vorliegend bevorzugt 0,2 Hz hergestellt, mit jeweiligen Dicken der Einzellagen von etwa 100 nm. Mit höherer Frequenz von z.B. 1 Hz - 100 Hz hergestellte Schichten sind vorteilhaft z.B. als Elektrode für Silicium-Lithiumbatterien geeignet, mit jeweiligen Dicken der Einzellagen von unter 1 nm bis einige 10 nm.

Durch stetige Erhöhung der Intensität der aufmodulierten Stromschwingung wird eine Lagenstruktur erzeugt, die in der Lage ist durch Verspannung erzeugten mechanischen Stress graduell abzubauen und dadurch eine stressarme Oberflächenlage herzustellen.

Eine solche Stromführung, beispielsweise in der Frequenz so angepasst dass Dicken von Einzellagen im Bereich z.B. optischer Wellenlängen entstehen, erzeugt Strukturen mit stetig in der Dicke anwachsenden Einzellagen, sogenannte verstimmte ("chirped") Bragg-Reflektoren, die besonders breitbandig reflektieren.

Durch Ergänzung des in Fig. 5 gezeigten Stromprofils mit einem oder mehreren Peaks wie in Fig. 7 gezeigt werden zwei oder mehrere Einzellagen erzeugt, die in sich wiederum eine Einzellagen-Struktur aufweisen. Diese können vorteilhafterweise so ausgeführt sein, dass sie sich mechanisch voneinander trennen lassen, z.B. zur Verwendung als Elektroden für Silicium-Lithiumbatterien.

Der Schutzbereich des europäischen Patents wird durch die Patentansprüche bestimmt.

## Patentansprüche

1. Vorrichtung zum einseitigen Ätzen einer Halbleiterschicht (2),
mit
- zumindest einem Ätzbecken (1) zur Aufnahme eines Elektrolyten (3),
- einer ersten Elektrode (4), welche zur elektrischen Kontaktierung des sich bei Benutzung in dem Ätzbecken (1) befindenden Elektrolyten (3) angeordnet ist,
- zumindest einer zweiten Elektrode (5), welche zur mittelbaren oder unmittelbaren elektrischen Kontaktierung der Halbleiterschicht (2) angeordnet ist,
- zumindest einer elektrischen Stromquelle (9), welche mit der ersten und der zweiten Elektrode (4, 5) zum Erzeugen eines Ätzstroms elektrisch leitend verbunden ist und
- zumindest einer Transportvorrichtung zum Transport der Halbleiterschicht (2) relativ zu dem Ätzbecken (1), derart, dass im Wesentlichen nur eine zu ätzende Ätzseite der Halbleiterschicht (2) durch den sich bei Benutzung in dem Ätzbecken (1) befindenden Elektrolyten (3) benetzbar ist,
wobei die Stromquelle (9) als variable Stromquelle (9) ausgebildet ist und die Vorrichtung eine Steuereinheit (10) zur Steuerung der variablen Stromquelle (9) aufweist, wobei die Vorrichtung ausgebildet ist, dass der Ätzstrom während des Ätzvorgangs mittels der Steuereinheit (10) automatisch änderbar ist, **dadurch gekennzeichnet, dass** die Vorrichtung einen Sensor zur Detektion von Geometrie- oder Materialeigenschaften der Halbleiterschicht (2) aufweist und dass der Sensor mit der Steuereinheit (10) zusammenwirkend ausgebildet ist, um den Ätzstrom abhängig von den Sensordaten zu steuern.

2. Vorrichtung nach Anspruch 1,
**dadurch gekennzeichnet,**
**dass** die Steuereinheit (10) derart ausgebildet ist, dass der Ätzstrom durch Vorgabe eines zeitlichen Verlaufs steuerbar ist, insbesondere durch Vorgabe eines zu Beginn des Ätzvorgangs anschwellenden und/oder zum Ende des Ätzvorgangs abschwellenden Ätzstroms und/oder zur Vorgabe eines zeitlich modulierten, insbesondere sinusartig modulierten Ätzstroms.

3. Vorrichtung nach einem der vorangegangenen Ansprüche,
**dadurch gekennzeichnet,**
**dass** die Steuereinheit (10) derart ausgebildet ist, dass der Ätzstrom abhängig von einem Steuersignal, insbesondere einem Detektorsignal steuerbar ist.

4. Vorrichtung nach einem der vorangegangenen Ansprüche,
**dadurch gekennzeichnet,**
**dass** die Vorrichtung einen Positionssensor (11) zur Detektion zumindest einer Positionierung der Halbleiterschicht (2) relativ zu dem Ätzbecken (1) aufweist und dass der Positionssensor (11) mit der Steuereinheit (10) zusammenwirkend ausgebildet ist, insbesondere, dass der Positionssensor (11) derart angeordnet und ausgebildet ist, um eine Position der Halbleiterschicht (2) zu detektieren, bevor die Halbleiterschicht (2) mit dem sich bei Benutzung in der Ätzkammer befindlichen Elektrolyten (3) benetzt wird.

5. Vorrichtung nach einem der vorangegangenen Ansprüche,
**dadurch gekennzeichnet,**
**dass** die Vorrichtung ausgebildet ist, die Ätzstromdichte an der Halbleiterschicht (2) während des Ätzvorgangs konstant zu halten.

6. Vorrichtung nach einem der vorangegangenen Ansprüche,
**dadurch gekennzeichnet,**
**dass** der Sensor als Leitfähigkeitssensor ausgebildet ist und/oder dass der Sensor zur Bestimmung der Fläche der Halbleiterschicht (2) ausgebildet ist, um den Ätzstrom flächenproportional einzustellen.

7. Verfahren zum einseitigen Ätzen einer Halbleiterschicht (2),
mittels eines Ätzstroms zwischen einem Elektrolyten (3) und der Halbleiterschicht (2), wobei die Halbleiterschicht (2) im Wesentlichen einseitig von dem Elektrolyten (3) benetzt ist,
wobei die Halbleiterschicht (2) mittels einer Transportvorrichtung relativ zu einem Ätzbecken (1) derart transportiert wird, dass im Wesentlichen nur eine zu ätzende Ätzseite der Halbleiterschicht (2) durch einen sich bei Benutzung in dem Ätzbecken (1) befindenden Elektrolyten (3) benetzt wird,
wobei der sich bei Benutzung in dem Ätzbecken (1) befindende Elektrolyte (3) mittels einer ersten Elektrode (4) und die Halbleiterschicht (2) mittels zumindest einer zweiten Elektrode (5) kontaktiert wird,
wobei die erste und die zweite Elektrode (4, 5) zum Erzeugen eines Ätzstroms über zumindest eine elektrische Stromquelle (9), welche als variable Stromquelle (9) ausgebildet ist, elektrisch leitend verbunden wird, wobei während des Ätzvorgangs der Ätzstrom mittels einer Steuereinheit (10) zur Steuerung der variablen Stromquelle (9) automatisch variiert wird, **dadurch gekennzeichnet, dass** mittels eines Sensors Geometrie- oder Materialeigenschaften der Halbleiterschicht (2) detektiert werden und der Sensor mit der Steuereinheit (10) zusammenwirkend ausgebildet ist, um den Ätzstrom abhängig von den Sensordaten zu steuern.

8. Verfahren nach Anspruch 7,
**dadurch gekennzeichnet,**
**dass** während des Ätzvorgangs eine zyklische Modulation des Ätzstroms erfolgt, insbesondere eine sinusartige Modulation.

9. Verfahren nach einem der Ansprüche 7 bis 8,
**dadurch gekennzeichnet,**
**dass** die Halbleiterschicht (2) derart über eine mit den Elektrolyten (3) enthaltende Ätzkammer bewegt wird, dass die Halbleiterschicht (2) im Wesentlichen einseitig von dem Elektrolyten (3) benetzt wird,
wobei beim Einfahren der Halbleiterschicht (2) der Ätzstrom ansteigt und/oder bei Herausfahren der Halbleiterschicht (2) der Ätzstrom abnimmt.

10. Verfahren nach Anspruch 9,
**dadurch gekennzeichnet,**
**dass** beim Einfahren der Ätzstrom stetig ansteigt, insbesondere proportional zu der von dem Elektrolyten (3) bedeckten Fläche ansteigt und/oder beim Herausfahren der Ätzstrom stetig abnimmt, insbesondere proportional zu der vom Elektrolyten (3) bedeckten Fläche abnimmt.

11. Verfahren nach einem der Ansprüche 7 bis 10,
**dadurch gekennzeichnet,**
**dass** der Ätzstrom abhängig von der Position der Halbleiterschicht (2) zu dem Elektrolyten (3) variiert wird.

12. Verfahren nach Anspruch 8 und einem der Ansprüche 9 bis 11,
**dadurch gekennzeichnet,**
**dass** der Ätzstrom zyklisch moduliert wird und
**dass** im zeitlichen Mittel beim Einfahren der Halbleiterschicht (2) der Ätzstrom ansteigt und/oder im zeitlichen Mittel bei Herausfahren der Halbleiterschicht (2) der Ätzstrom abnimmt.

13. Verfahren nach einem der Ansprüche 7 bis 12,
**dadurch gekennzeichnet,**
**dass** der Ätzstrom derart gesteuert wird, dass die Ätzstromdichte an der Halbleiterschicht (2) während des Ätzvorgangs konstant ist.

14. Verfahren nach einem der Ansprüche 7 bis 13,
**dadurch gekennzeichnet,**
**dass** der Ätzsstrom abhängig von den Messparametern mindestens eines Sensors variiert wird.

15. Verwendung einer Vorrichtung gemäß einem der Ansprüche 1 bis 6 zur Herstellung einer porösen Halbleiterschicht (2), und/oder Verwendung einer Vorrichtung gemäß einem der Ansprüche 1 bis 6 zur Herstellung eines Trägersubstrats für eine epitaktische Abscheidung einer Halbleiterschicht, insbesondere einer Siliziumschicht.

## Claims

1. Device for etching one side of a semiconductor layer (2), having
- at least one etching tank (1) for receiving an electrolyte (3),
- a first electrode (4) which is arranged for making electrical contact with the electrolyte (3) situated in the etching tank (1) during use,
- at least one second electrode (5) which is arranged for making indirect or direct electrical contact with the semiconductor layer (2),
- at least one electric current source (9) which is electrically conductively connected to the first and second electrodes (4, 5) to generate an etching current,
- at least one transport device for transporting the semiconductor layer (2) relative to the etching tank (1) in such a way that substantially only an etching side to be etched of the semiconductor layer (2) is wettable by the electrolyte (3) situated in the etching tank (1) during use,
wherein the current source (9) is configured as a variable current source (9) and the device has a controller (10) for controlling the variable current source (9), wherein the device is configured such that the etching current is automatically changeable by the controller (10) during the etching process, **characterised in that** the device has a sensor for detecting geometrical or material properties of the semiconductor layer (2), and **in that** the sensor is configured to cooperate with the controller (10) in order to control the etching current depending on the sensor data.

2. Device according to claim 1,
**characterised in that**
the controller (10) is configured in such a way that the etching current is controllable by predefining a temporal profile, in particular by predefining an etching current which rises at the beginning of the etching process and/or falls at the end of the etching process and/or for predefining a temporally modulated, in particular sinusoidally modulated etching current.

3. Device according to any one of the preceding claims,
**characterised in that**
the controller (10) is configured in such a way that the etching current is controllable depending on a control signal, in particular a detector signal.

4. Device according to any one of the preceding claims,
**characterised in that**
the device has a position sensor (11) for detecting at least one positioning of the semiconductor layer (2) relative to the etching tank (1), and **in that** the position sensor (11) is configured to cooperate with the controller (10), in particular **in that** the position sensor (11) is arranged and configured in such a way as to detect a position of the semiconductor layer (2) before the semiconductor layer (2) is wetted with the electrolyte (3) situated in the etching chamber during use.

5. Device according to any one of the preceding claims,
**characterised in that**
the device is configured to keep the etching current density at the semiconductor layer (2) constant during the etching process.

6. Device according to any one of the preceding claims,
**characterised in that**
the sensor is configured as a conductivity sensor and/or **in that** the sensor is configured to determine the area of the semiconductor layer (2) in order to set the etching current in proportion to the area.

7. Method for etching one side of a semiconductor layer (2),
using an etching current between an electrolyte (3) and the semiconductor layer (2), wherein the semiconductor layer (2) is substantially wetted on one side by the electrolyte (3),
wherein the semiconductor layer (2) is transported by a transport device relative to the etching tank (1) in such a way that substantially only an etching side to be etched of the semiconductor layer (2) is wettable by an electrolyte (3) situated in the etching tank (1) during use, wherein the electrolyte (3) situated in the etching tank (1) during use is contacted by a first electrode (4) and the semiconductor layer (2) is contacted by at least one second electrode (5),
wherein the first and second electrodes (4, 5) are electrically conductively connected via at least one electric current source (9), which is configured as a variable current source (9), in order to generate an etching current, wherein during the etching process the etching current is automatically varied by means of a controller (10) for controlling the variable current source (9), **characterised in that** geometrical or material properties of the semiconductor layer (2) are detected by means of a sensor and the sensor is configured to cooperate with the controller (10) in order to control the etching current depending on the sensor data.

8. Method according to claim 7,
**characterised in that**
during the etching process a cyclic modulation of the etching current takes place, in particular a sinusoidal modulation.

9. Method according to any one of claims 7 to 8,
**characterised in that**
the semiconductor layer (2) is moved over an etching chamber containing the electrolyte (3) in such a way that the semiconductor layer (2) is wetted substantially on one side by the electrolyte (3), wherein the etching current increases when the semiconductor layer (2) enters and/or the etching current decreases when the semiconductor layer (2) exits.

10. Method according to claim 9,
**characterised in that**
the etching current increases continuously upon entrance, in particular in proportion to the area covered by the electrolyte (3), and/or the etching current decreases continuously upon exit, in particular in proportion to the area covered by the electrolyte (3).

11. Method according to any one of claims 7 to 10,
**characterised in that**
the etching current is varied depending on the position of the semiconductor layer (2) relative to the electrolyte (3).

12. Method according to claim 8 and any one of claims 9 to 11,
**characterised in that**
the etching current is cyclically modulated and
the etching current increases on average over time when the semiconductor layer (2) enters and/or the etching current decreases on average over time when the semiconductor layer (2) exits.

13. Method according to any one of claims 7 to 12,
**characterised in that**
the etching current is controlled in such a way that the etching current density at the semiconductor layer (2) is constant during the etching process.

14. Method according to any one of claims 7 to 13,
**characterised in that**
the etching current is varied depending on the measuring parameters of at least one sensor.

15. Use of a device according to any one of claims 1 to 6 for producing a porous semiconductor layer (2), and/or use of a device according to any one of claims 1 to 6 for producing a carrier substrate for epitaxial deposition of a semiconductor layer, in particular a silicon layer.

## Revendications

1. Dispositif de gravure unilatérale d'une couche de semi-conducteur (2), avec
- au moins une cuvette de gravure (1) pour la réception d'un électrolyte (3),
- une première électrode (4) qui est agencée pour la mise en contact électrique de l'électrolyte (3) se trouvant lors de l'utilisation dans la cuvette de gravure (1),
- au moins une seconde électrode (5) qui est agencée pour la mise en contact électrique directe ou indirecte de la couche de semi-conducteur (2),
- au moins une source de courant (9) électrique qui est reliée par électroconduction à la première et à la seconde électrode (4, 5) pour la génération d'un courant de gravure et
- au moins un dispositif de transport pour le transport de la couche de semi-conducteur (2) par rapport à la cuvette de gravure (1) de telle manière que sensiblement un seul côté de gravure à graver de la couche de semi-conducteur (2) puisse être mouillé par l'électrolyte (3) se trouvant lors de l'utilisation dans la cuvette de gravure (1),
dans lequel la source de courant (9) est réalisée comme source de courant (9) variable et le dispositif présente un dispositif de commande (10) pour la commande de la source de courant (9) variable, dans lequel le dispositif est réalisé, que le courant de gravure peut être automatiquement modifié pendant le processus de gravure au moyen du dispositif de commande (10), **caractérisé en ce que** le dispositif présente un capteur pour la détection de propriétés de géométrie ou de matériau de la couche de semi-conducteur (2) et que le capteur est réalisé de manière à coopérer avec le dispositif de commande (10) afin de commander le courant de gravure en fonction des données de capteur.

2. Dispositif selon la revendication 1,
**caractérisé en ce que**
le dispositif de commande (10) est réalisé de telle manière que le courant de gravure puisse être commandé par prescription d'une étendue temporelle, en particulier par prescription d'un courant de gravure gonflant au débit du processus de gravure et/ou dégonflant à la fin du processus de gravure et/ou pour la prescription d'un courant de gravure modulé temporellement, modulé en particulier de manière sinusoïdale.

3. Dispositif selon l'une quelconque des revendications précédentes,
**caractérisé en ce que**
le dispositif de commande (10) est réalisé de telle manière que le courant de gravure puisse être commandé en fonction d'un signal de commande, en particulier d'un signal de détecteur.

4. Dispositif selon l'une quelconque des revendications précédentes,
**caractérisé en ce que**
le dispositif présente un capteur de position (11) pour la détection au moins d'un positionnement de la couche de semi-conducteur (2) par rapport à la cuvette de gravure (1) et que le capteur de position (11) est réalisé de manière à coopérer avec le dispositif de commande (10), en particulier que le capteur de position (11) est agencé et réalisé de manière à détecter une position de la couche de semi-conducteur (2) avant que la couche de semi-conducteur (2) ne soit mouillée avec l'électrolyte (3) se trouvant lors de l'utilisation dans la chambre de gravure.

5. Dispositif selon l'une quelconque des revendications précédentes,
**caractérisé en ce que**
le dispositif est réalisé afin de maintenir constante la densité de courant de gravure au niveau de la couche de semi-conducteur (2) pendant le processus de gravure.

6. Dispositif selon l'une quelconque des revendications précédentes,
**caractérisé en ce que**
le capteur est réalisé comme capteur de conductivité et/ou que le capteur est réalisé pour la détermination de la surface de la couche de semi-conducteur (2) afin de régler le courant de gravure de manière proportionnel à la surface.

7. Procédé de gravure unilatérale d'une couche de semi-conducteur (2),
au moyen d'un courant de gravure entre un électrolyte (3) et la couche de semi-conducteur (2), dans lequel la couche de semi-conducteur (2) est mouillée sensiblement unilatéralement par l'électrolyte (3),
dans lequel la couche de semi-conducteur (2) est transportée au moyen d'un dispositif de transport par rapport à une cuvette de gravure (1) de telle manière que sensiblement un seul côté de gravure à graver de la couche de semi-conducteur (2) puisse être mouillé par l'électrolyte (3) se trouvant lors de l'utilisation dans la cuvette de gravure (1), dans lequel l'électrolyte (3) se trouvant lors de l'utilisation dans la cuvette de gravure (1) est mis en contact au moyen d'une première électrode (4) et la couche de semi-conducteur (2) est mise en contact au moyen d'au moins une seconde électrode (5),
dans lequel la première et la seconde électrode (4, 5) sont reliées par électroconduction pour la génération d'un courant de gravure par le biais au moins d'une source de courant (9) électrique qui est réalisée comme source de courant (9) variable, dans lequel pendant le processus de gravure le courant de gravure est automatiquement varié au moyen d'un dispositif de commande (10) pour la commande de la source de courant (9) variable, **caractérisé en ce que** des propriétés de géométrie ou de matériau de la couche de semi-conducteur (2) sont détectées au moyen d'un capteur et le capteur est réalisé de manière à coopérer avec le dispositif de commande (10) afin de commander le courant de gravure en fonction des données de capteur.

8. Procédé selon la revendication 7,
**caractérisé en ce que**
pendant le processus de gravure une modulation cyclique du courant de gravure est effectuée, en particulier une modulation sinusoïdale.

9. Procédé selon l'une quelconque des revendications 7 à 8,
**caractérisé en ce que**
la couche de semi-conducteur (2) est déplacée par le biais d'une chambre de gravure contenant des électrolytes (3) de telle manière que la couche de semi-conducteur (2) soit mouillée sensiblement unilatéralement par l'électrolyte (3), dans lequel lors de la rentrée de la couche de semi-conducteur (2), le courant de gravure augmente et/ou lors de la sortie de la couche de semi-conducteur (2), le courant de gravure diminue.

10. Procédé selon la revendication 9,
**caractérisé en ce que**
lors de la rentrée, le courant de gravure augmente en continu, augmente en particulier proportionnellement à la surface recouverte par l'électrolyte (3) et/ou lors de la sortie, le courant de gravure diminue en continu, diminue en particulier proportionnellement à la surface recouverte par l'électrolyte (3).

11. Procédé selon l'une quelconque des revendications 7 à 10,
**caractérisé en ce que**
le courant de gravure est varié en fonction de la position de la couche de semi-conducteur (2) par rapport à l'électrolyte (3).

12. Procédé selon la revendication 8 et l'une quelconque des revendications 9 à 11,
**caractérisé en ce que**
le courant de gravure est modulé de manière cyclique et
en moyenne dans le temps lors de la rentrée de la couche de semi-conducteur (2), le courant de gravure augmente et/ou en moyenne dans le temps lors de la sortie de la couche de semi-conducteur (2), le courant de gravure diminue.

13. Procédé selon l'une quelconque des revendications 7 à 12,
**caractérisé en ce que**
le courant de gravure est commandé de telle manière que la densité de courant de gravure soit constante au niveau de la couche de semi-conducteur (2) pendant le processus de gravure.

14. Procédé selon l'une quelconque des revendications 7 à 13,
**caractérisé en ce que**
le courant de gravure est varié en fonction des paramètres de mesure au moins d'un capteur.

15. Utilisation d'un dispositif selon l'une quelconque des revendications 1 à 6 pour la fabrication d'une couche de semi-conducteur (2) poreuse, et/ou utilisation d'un dispositif selon l'une quelconque des revendications 1 à 6 pour la fabrication d'un substrat porteur pour une séparation épitaxiale d'une couche de semi-conducteur, en particulier d'une couche de silicium.
